# EUROPEAN PATENT APPLICATION

(11) **EP 3 780 910 A1**
(43) Date of publication of application: **17.02.2021**
(21) Application number: 19777185.0
(22) Date of filing: 01.04.2019
(51) Int. Cl.: H05B 33/04, B32B 15/08, B32B 27/18, B32B 27/32, H01L 23/29, H01L 23/31, H01L 51/50

(54) **ENCAPSULATION MATERIAL FOR ORGANIC ELECTRONIC DEVICES**

(30) Priority: 30.03.2018 JP 2018069255
(71) Applicant: Toyo Seikan Group Holdings, Ltd., Shinagawa-ku Tokyo 141-8627 (JP)
(72) Inventor: SUGIURA, Chiho, Tokyo 141-8627 (JP); OBU, Yusuke, Tokyo 141-8627 (JP); HAYASHI, Kenji, Tokyo 141-8627 (JP); KAWAKUBO, Yutaka, Tokyo 141-8627 (JP)
(74) Representative: J A Kemp LLP
(86) International application number: PCT/JP2019/014517
(87) International publication number: WO 2019/189930

(57) **Abstract**

A sealing member used for absorbing the water in the interior of the organic electronic devices and for holding the interior of the devices in a dry state. The sealing member comprises a laminate of a barrier sheet 5 provided with a metal foil 5a and a moisture absorbing film 3.

## Description

### Technical Field:

This invention relates to a sealing member for organic electronic devices. More specifically, the invention relates to a sealing member that is used for absorbing the water in the interior of the devices and for holding the interior of the devices in a dry state.

### Background Art:

Moisture absorbing sheets having a moisture absorbing resin layer with a desiccant being dispersed therein, have heretofore been widely used for absorbing the moisture and preventing the moisture.

The moisture absorbing sheets that are proposed are having a variety of layer constitutions. A patent document 1 proposes a moisture absorbing sheet comprising a desiccant layer, a moisture-permeable sheet provided on one surface of the desiccant layer, and an adhesive layer provided on the other surface of the desiccant layer. As the moisture-permeable sheet, there has been described that there can be used a cellophane sheet, an acetate sheet, a nylon sheet and the like sheets.

Here, leakage of electric charges must be avoided when it comes to the organic electronic devices such as organic electroluminescent (organic EL) devices, solar cells, tough panels and electronic papers that have been developed in recent years. Therefore, a high degree of water-barrier property is required for the plastic substrates for forming circuit boards and for the plastic substrates such as films for sealing the circuit boards. At the same time, it is, further, required to maintain the interior of the devices in a dry state.

However, the conventional moisture absorbing sheet disclosed in the patent document 1 is not capable of exhibiting properties satisfactory enough for use as a sealing member for maintaining the interior of the organic electronic devices in a dry state. Even if having absorbed the water in the device, the moisture absorbing sheet also absorbs the water infiltrating from the exterior of the device. Accordingly, the desiccant in the moisture absorbing sheet is brought into a saturated state within short periods of time and, therefore, loses the capability for absorbing the water or releases the absorbed water into the interior of the device. Therefore, further improvements are necessary.

### Prior Art Documents:

### Patent Documents:

Patent document 1: Japanese Patent Laid-Open No. 2006-326838

### Outline of the Invention:

### Problems that the Invention is to Solve:

It is, therefore, an object of the present invention to provide a sealing member that is used for absorbing the water in the interior of the organic electronic devices and for holding the interior of the devices in a dry state.

### Means for Solving the Problems:

According to the invention, there is provided a sealing member for organic electronic devises, comprising a laminate of a barrier sheet provided with a metal foil and a moisture absorbing film.

In the sealing member for organic electronic devices of the invention, it is desired that:
(1) The sealing member is used being so arranged that the moisture absorbing film of the laminate faces the interior of the device;
(2) The sealing member is used being stuck to a portion of the organic electronic device where the transmission of light is not required;
(3) The moisture absorbing film has a moisture absorbing resin layer in which a desiccant has been dispersed;
(4) The moisture absorbing resin layer comprises an olefin resin in which the desiccant has been dispersed; and
(5) The desiccant is an agent of the type that chemically traps the water upon the reaction with the water.

### Effects of the Invention:

The sealing member for organic electronic devices of the present invention is used being so arranged that the moisture absorbing film that constitutes the laminate is positioned in the interior of the device. Due to the moisture absorbing capability of the moisture absorbing film, the interior of the device can be maintained in a dry state. Here, the greatest feature of the sealing member is that a barrier sheet positioned on the back surface of the moisture absorbing film (on the surface of the side opposite to the device) is provided with a metal foil.

Namely, by using the sealing member of the present invention, the infiltration of water from the exterior of the device is completely shut off by the metal foil in the barrier sheet. Therefore, no water infiltrates into the moisture absorbing film from the exterior of the device; i.e., the moisture absorbing film is allowed to selectively absorb the water from the interior of the device.

According to the present invention as descried above, the moisture absorbing capability of the moisture absorbing film can be exhibited to a maximum degree to maintain the interior of the organic electronic device in a dry state and, therefore, to effectively avoid inconveniences such as leakage of electric charge caused by the water.

In the invention, the sealing member for organic electronic devices is provided with the metal foil. Basically, therefore, the sealing member is used for a portion of the device where the transmission of light is not required (e.g., for the surface of a solar cell where no light is being received, for the surface of an organic electroluminescent device where no light is being emitted, or for the side surfaces of such devices).

### Brief Description of the Drawing:

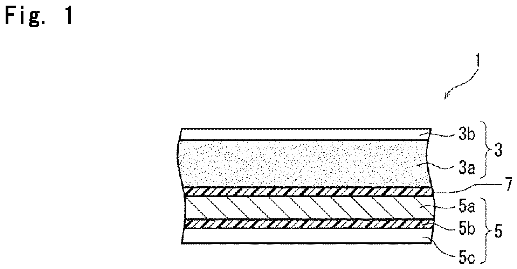

[Fig. 1] It is a sectional view schematically illustrating a structure of layers of a sealing member for organic electronic devices according to the present invention.

### Modes for Carrying Out the Invention:

Referring to Fig. 1, a sealing member for organic electronic devices of the invention generally designated at 1 has a laminated structure in which a moisture absorbing film 3 and a barrier sheet 5 are laminated one upon the other via an adhesive layer 7. To use the sealing member 1, the moisture absorbing film 3 is stuck to a predetermined portion (not shown) of the organic electronic device by using an adhesive.

### <Moisture absorbing film 3>

The moisture absorbing film 3 comprises a moisture absorbing resin layer 3a and is, usually, provided on the surface thereof with an underlying adhesive layer 3b.

The moisture absorbing resin layer 3a absorbs the water to maintain the interior of the device in a dry state, and is a layer of a resin in which a desiccant is dispersed.

As the desiccant in the moisture absorbing resin layer 3a, there is used an inorganic or organic desiccant that has been known per se.

As the inorganic desiccant, there can be exemplified clay minerals such as zeolite, alumina, active carbon and montmorillonite, as well as silica gel, calcium oxide, barium oxide, calcium chloride, magnesium sulfate, etc.

As the organic desiccant, there can be exemplified an anionic polymer or a crosslinked product of a partly neutralized product thereof. As the anionic polymer, there can be exemplified carboxylic acid monomers such as (meth) acrylic acid, anhydrous maleic acid; sulfonic acid monomers such as halogenated vinylsulfonic acid, stylenesulfonic acid, vinylsulfonic acid; phosphonic acid monomers such as vinylphosphoric acid; and those obtained by polymerizing at least one kind of the anionic monomers represented by salts of these monomers or obtained by copolymerizing at least one kind thereof with another monomer.

The invention more favorably uses a desiccant that shows chemical adsorption upon the reaction with the water, such as calcium oxide or calcium chloride than a desiccant that traps the water relying on the physical adsorption, such as zeolite or silica gel from such a standpoint that the desiccant keeps the absorbed water trapped therein without releasing it.

The desiccant should have a small grain size from such a standpoint that it can be homogeneously dispersed in the resin and that it has a large specific surface area. For instance, the desiccant should have a mean primary grain size (D50) of not more than 20 *µ*m calculated as the volume as measured by the laser diffraction·light scattering method and should, usually, be dispersed in the moisture absorbing resin layer 3a in an amount of 5 to 80 parts by mass per 100 parts by mass of the resin that is the matrix.

As the resin (i.e., resin matrix) in which the desiccant is to be dispersed, there can be used a widely known thermoplastic resin without any special limitation. In general, from the standpoint of cost and that it can be easily adhered to the barrier sheet 5, there can be favorably used an olefin resin such as low-density polyethylene, high-density polyethylene, polypropylene, poly 1-butene, poly 4-methyl-1-pentene, or a random or block copolymer of *α* -olefins, such as ethylene, propylene, 1-butene or 4-methyl-1-pentene, or a cyclic olefin copolymer.

In the invention, among the above-mentioned olefin resins, there are preferably used the low-density polyethylene (LDPE), linear low-density polyethylene (LLDPE), polypropylene (PP) and a blend thereof from the standpoint of relatively low moisture absorbing property and preventing the desiccant from losing its activity before it is used. Among them, the low-density polyethylene (LDPE) and linear low-density polyethylene (LLDPE) are preferred.

The thickness of the moisture absorbing resin layer 3a is not specifically limited and may be suitably determined depending on the size of the device to which the sealing member 1 is applied.

To use the sealing member 1 of the invention, the surface of the moisture absorbing resin layer 3a is stuck and fixed to a predetermined device by utilizing the blocking property of the resin that forms the moisture absorbing resin layer 3a. Usually, however, the underlying adhesive layer 3b is desirably provided on the surface of the moisture absorbing resin 3a.

The underlying adhesive layer 3b is formed by using the same resin as the resin that is used for forming the moisture absorbing resin layer 3a, e.g., by using the olefin resin. That is, provision of the underlying adhesive layer 3b makes it possible to make smooth the surface on where the desiccant is dispersed. By adding a filler to the underlying adhesive layer 3b, furthermore, the sealing member 1 can be adhered and fixed to the device more firmly than when the moisture absorbing resin layer 3a is directly stuck to the device. Moreover, the underlying adhesive layer 3b excellently adheres to a pressure sensitive adhesive, too. Therefore, upon applying the pressure sensitive adhesive or the adhesive agent onto the underlying adhesive layer 3b, the sealing member can be fixed to the device more firmly.

In providing the underlying adhesive layer 3b as described above, it should not happen that the moisture absorbing property of the moisture absorbing resin layer 3a is impaired by the underlying adhesive layer 3b. Therefore, the underlying adhesive layer 3b should have a moisture permeability of not less than 40 g/m²/day and, specifically, not less than 60 g/m²/day at, for example, 40°C and 90%RH. If the underlying adhesive layer 3b has a low moisture permeability, then it becomes probable that the moisture in the interior of the device might not be effectively absorbed by the moisture absorbing resin layer 3a.

Therefore, the underlying adhesive layer 3b is provided on the surface of the moisture absorbing resin layer 3a maintaining a thickness of not more than a predetermined value (e.g., not more than 30 *µ*m) so as to secure the moisture permeability as described above.

Moreover, though not shown, on the back surface of the moisture absorbing resin layer 3a (on the side opposite to the underlying adhesive layer 3b), there can be provided a protection resin layer to prevent the moisture absorbing resin layer 3a from absorbing the moisture during the step of forming the moisture absorbing film 3.

The protection resin layer can be formed by using various kinds of thermoplastic resins. In general, however, the protection resin layer is formed by using the same resin as the resin used for forming the moisture absorbing resin layer 3a, e.g., by using a thermoplastic polyester such as olefin resin, polyethylene terephthalate (PET), polybutylene terephthalate or polyethylene naphthalate (PEN) and, more preferably, by using an olefin resin. From the standpoint of favorable adhesiveness to the moisture absorbing resin layer 3, it is most desired to use the ethylene resin or the propylene resin.

The above-mentioned moisture absorbing film 3 is obtained by the extrusion forming or the co-extrusion forming depending upon its layer constitution.

### <Barrier sheet 5>

In the invention, the barrier sheet 5 is provided on the back surface of the moisture absorbing film 3 (i.e., on the surface of the moisture absorbing resin layer 3a opposite to the device side).

The barrier sheet 5 is laminated on the moisture absorbing film 3 (moisture absorbing resin layer 3a) via the adhesive layer 7 that will be described later. Here, as will be understood from Fig. 1, the barrier sheet 5 must be provided with a metal foil 5a such as aluminum foil. Upon laminating the barrier sheet 5 having the metal foil 5a on the back surface of the moisture absorbing film 3, the water can be completely prevented from infiltrating into the moisture absorbing resin layer 3a from the exterior. Therefore, the moisture absorbing property of the moisture absorbing resin layer 3a selectively works to absorb the water in the interior of the device. Accordingly, the interior of the device can be maintained in a dry state for extended periods of time.

There is no limitation on the structure of the barrier sheet 5 so far as it has the metal foil 5a. For example, the barrier sheet 5 may have such a structure that the metal foil 5a only is laminated on the moisture absorbing film 3. Usually, however, it is desired that a surface protection resin layer 5c is formed on the metal foil 5a via an adhesive layer 5b.

The adhesive layer 5b may be formed by using an olefin resin modified with an *α*, *β*-unsaturated carboxylic acid (e.g., maleic anhydride, etc.) or an urethane type adhesive for dry lamination. Usually, however, the adhesive layer 5b is formed by using a thermoplastic resin having heat-sealing property, such as an olefin resin.

The surface protection resin layer 5c is a resin layer that is provided for preventing the metal foil 5a from being scratched or from being oxidized and deteriorated, and is formed by using any resin that has been known per se. Usually, however, the surface protection resin layer 5c is formed by using a polyester resin such as polyethylene terephthalate, or an olefin resin such as polyethylene or polypropylene. Specifically, however, the surface protection resin layer 5c is formed by using a polyester resin.

Usually, the surface protection resin layer 5c may have a thickness of about 1 to about 30 *µ*m.

The barrier sheet 5 is obtained by preparing, on one surface of the metal foil 5a, a coating solution in which an adhesive resin for forming the adhesive layer 5b is dissolved or dispersed, by applying the coating solution on one surface of the metal foil 5a followed by drying, and adhering thereon, under the application of heat and pressure, a film or a sheet of the surface protection resin layer 5c that is obtained through an extrusion forming or the like method.

The barrier sheet 5 can be also obtained by melt-extruding the resins for forming the adhesive layer 5b and the surface protection resin layer 5c simultaneously or successively onto the surface of the metal foil 5a.

### <Adhesive layer 7>

The adhesive layer for adhering the moisture absorbing film 3 and the barrier sheet 5 together may be formed by using any adhesive resin so far as it is capable of firmly adhering and fixing the metal foil 5a and the moisture absorbing film 3 (moisture absorbing resin layer 3a or a protection resin layer that has not been shown) together. Usually, however, it is desired that the adhesive layer is formed by using the same adhesive resin as the one for forming the above-mentioned adhesive layer 5b and, specifically, by using the thermoplastic resin having the heat-sealing property.

### <Production of the sealing member 1 and its use>

To produce the sealing member 1 having the above-mentioned layer structure, the moisture absorbing film 3 and the barrier sheet 5 that have been prepared in advance are adhered together by using the adhesive that forms the adhesive layer 7. As for the operation for adhesion, a suitable means can be employed depending on the kind of the adhesive. When they are to be adhered together by using, for example, a thermoplastic resin having heat-sealing property, such as olefin resin, the thermoplastic resin having heat-sealing property is applied onto the surface of the metal foil 5a or onto the surfaces of both the metal foil 5a and the moisture absorbing resin layer 3a, and they are adhered together by the application of heat and pressure to thereby obtain the sealing member 1 of the present invention.

The thus obtained sealing member 1 of the present invention is used by sticking the surface thereof on the side of the moisture absorbing film 3 to a predetermined portion of the organic electronic device. Namely, the water in the interior of device is absorbed and hence the interior thereof is maintained in the dry state.

The sealing member 1 of the present invention can be applied to every organic electronic device without limitation, i.e., to such electronic devices that must avoid the leakage of electric charges caused by the presence of water, such as organic EL devices, solar cells, touch panels and the like devices.

There is no specific limitation on sticking the sealing member 1. Usually, however, the sealing member 1 is stuck by using a widely known pressure sensitive adhesive such as acrylic adhesive or silicone adhesive. Thus the sealing member 1 can be held maintaining stability over extended periods of time. In case the sealing member 1 (moisture absorbing film 3) ceases to exhibits the moisture absorbing capability, then the sealing member 1 is removed and is replaced by a new one.

The sealing member 1 of the invention has the metal foil 5a. Therefore, the sealing member 1 is used being stuck to the surface of the device on the side where the transmission of light is not required, e.g., being stuck to the surface of a solar cell where no light is being received, the surface of an organic electroluminescent device where no light is being emitted, or the side surfaces of a variety of devices.

Since the moisture absorbing film 3 (moisture absorbing resin layer 3a) exhibits its moisture absorbing capability selectively in the interior of the devices, the sealing member 1 of the present invention exhibits the moisture absorbing capability over extended periods of time and maintains the interior of the device in a dry state over extended periods of time.

### Description of Reference Numerals:

- 1:: sealing member
- 3:: moisture absorbing film
- 3a:: moisture absorbing resin layer
- 3b:: underlying adhesive layer
- 5:: barrier sheet
- 5a:: metal foil
- 5b:: adhesive layer
- 5c:: surface protection resin layer
- 7:: adhesive layer

## Claims

1. A sealing member for organic electronic devises, comprising a laminate of a barrier sheet provided with a metal foil and a moisture absorbing film.

2. The sealing member according to claim 1, wherein the sealing member is used being so arranged that the moisture absorbing film of said laminate faces the interior of the device.

3. The sealing member according to claim 2, wherein the sealing member is used being stuck to a portion of the organic electronic device where the transmission of light is not required.

4. The sealing member according to claim 1, wherein said moisture absorbing film has a moisture absorbing resin layer in which a desiccant has been dispersed.

5. The sealing member according to claim 4, wherein said moisture absorbing resin layer comprises an olefin resin in which the desiccant has been dispersed.

6. The sealing member according to claim 4, wherein said desiccant is an agent of the type that chemically traps the water upon the reaction with the water.
